# DEMANDE DE BREVET EUROPEEN

(11) **EP 4 079 713 A1**
(43) Date de publication de la demande: **26.10.2022**
(21) Numéro de dépôt: 21169680.2
(22) Date de dépôt: 21.04.2021
(51) Int. Cl.: C04B 41/00, B44C 1/22, B44F 9/08, C04B 41/50, C04B 41/53, C04B 41/87, C04B 41/91, G04B 19/10, G04B 37/22, C23C 14/00, C23C 14/06, G04B 45/00, C04B 111/82

(54) **PROCÉDÉ DE RÉALISATION D'UNE PIÈCE EN CÉRAMIQUE À EFFET NACRÉ, NOTAMMENT POUR L'HORLOGERIE**

(71) Demandeur: Comadur S.A., 2400 Le Locle (CH)
(72) Inventeur: LINTYMER, Jan, 25000 Mamirolle (FR)
(74) Mandataire: ICB SA

(57) **Abrégé**

L'invention se rapporte à un procédé de de réalisation d'une pièce (10) en céramique à effet nacré, notamment pour l'horlogerie, le procédé comprenant les étapes suivantes :
- une étape de formation d'un corps (8) en céramique,
- une étape de dépôt d'une couche d'un composant d'oxy-nitrure (9) de type OxNy sur au moins une partie du corps (8) en céramique, et
- une étape d'oxydation d'au moins une partie (13) de la couche d'oxy-nitrure (9), de préférence par chauffage.

## Description

### Domaine technique de l'invention

L'invention se rapporte à un procédé de réalisation d'une pièce en céramique à effet nacré, notamment pour l'horlogerie.

### Arrière-plan technologique

L'invention trouvera une application dans la fabrication d'un composant d'habillage destiné, préférentiellement mais non limitativement, au domaine de l'horlogerie. Préférentiellement, un tel composant peut être par exemple une lunette de montre destinée à être rapportée sur une boite de montre, un maillon de bracelet, un cadran, une boite de montre, un élément de fermoir.

L'invention trouvera aussi une application dans la fabrication de composants d'habillage utilisés dans les domaines, de façon non exhaustive, de la téléphonie mobile et cellulaire, des terminaux informatiques notamment portables, par exemple pour former des coques de téléphone portable ou de tablettes, ou encore dans le domaine de la joaillerie ou bien de l'art de la table.

L'invention vise notamment des éléments constitués en des matériaux durs, à savoir résistants aux chocs et aux rayures. Ces matériaux durs peuvent être notamment de types céramiques techniques. En outre, chaque élément peut être constitué en dioxyde de zirconium ou « zircone », en dioxyde d'aluminium ou « alumine », en encore en un matériau composite intégrant un support en céramiques et une matrice métallique ou « cermet ». Chaque élément du composant d'habillage de l'invention peut aussi être constitué en saphir ou rubis synthétique.

Pour fabriquer ces pièces, on utilise un procédé comprenant les étapes suivantes :
- réalisation d'un précurseur à partir d'un mélange d'au moins un matériau en poudre avec un liant,
- formation d'un corps vert par injection dans un moule ou par pressage pour donner la forme de la pièce finale au corps vert,
- frittage dudit corps vert afin de le durcir et d'obtenir la pièce souhaitée;

Avec les procédés classiques, les pièces céramiques obtenues peuvent être colorées, par exemple en blanc. Il existe des procédés pour obtenir une couleur de céramique plus ou moins brillante ou plutôt mate.

Cependant, la variation est limitée à ces nuances de couleurs, et il est difficile d'obtenir d'autres nuances, de sorte qu'il manque des aspects de couleur intéressants pour de la céramique.

### Résumé de l'invention

L'invention a pour but de remédier aux inconvénients précités, et vise à fournir un procédé pour obtenir une pièce en céramique dont la couleur est nacrée, c'est-à-dire qui a des reflets irisés.

A cette fin, l'invention porte sur un procédé de réalisation d'une pièce en céramique à effet nacré, notamment pour l'horlogerie.

Le procédé est remarquable en ce qu'il comprend les étapes suivantes :
- une étape de formation d'un corps en céramique,
- une étape de dépôt d'une couche d'un composant d'oxy-nitrure de type OxNy sur au moins une partie du corps en céramique, et
- une étape d'oxydation d'au moins une partie de la couche d'oxy-nitrure, de préférence par chauffage.

Ainsi, le procédé permet d'obtenir une couleur nacrée à la surface de la céramique. En effet, l'oxydation de la couche d'oxy-nitrure à la surface de la partie de la pièce en céramique rend cette couche en partie transparente. La couleur du corps est visible à travers cette couche, ce qui produit les effets d'irisation, et par conséquent un rendu nacré.

Selon une forme de réalisation particulière de l'invention, le procédé l'étape de formation du corps en céramique comprend une sous-étape de réalisation d'un précurseur à partir d'un mélange d'au moins un matériau en poudre avec un liant.

Selon une forme de réalisation particulière de l'invention, l'étape de formation du corps en céramique comprend une sous-étape de formation d'un corps vert par injection dans un moule ou par pressage, le corps vert ayant la forme souhaitée pour le corps.

Selon une forme de réalisation particulière de l'invention, l'étape de formation du corps en céramique comprend une sous-étape de frittage du corps vert afin de le durcir et d'obtenir la forme souhaitée.

Selon une forme de réalisation particulière de l'invention, le corps formé lors de l'étape de formation du corps est monobloc, et de préférence en céramique blanche.

Selon une forme de réalisation particulière de l'invention, le procédé comprend une étape de structuration de la couche du composant d'oxy-nitrure avant l'étape d'oxydation de la couche.

Selon une forme de réalisation particulière de l'invention, l'étape de structuration est effectuée par photolithographie, ou par ablation directe, par exemple par laser.

Selon une forme de réalisation particulière de l'invention, le composant d'oxy-nitrure est à choisir parmi l'oxy-nitrure de zircone de type ZᵣOₓN_{y}, l'oxy-nitrure de Chrome de type CᵣOₓN ou l'oxy-nitrure de Titane de type TrOxNy.

Selon une forme de réalisation particulière de l'invention, le corps est chauffé à au moins 500°C, de préférence au moins 600°C, lors de l'étape d'oxydation

Selon une forme de réalisation particulière de l'invention, l'étape de dépôt de la couche d'oxy-nitrure est effectuée par un dépôt physique en phase vapeur de type PVD.

Selon une forme de réalisation particulière de l'invention, le corps en céramique formé lors de l'étape de formation du corps comprend de la zircone, de préférence en totalité.

Selon une forme de réalisation particulière de l'invention, comprend une étape de polissage du corps avant l'étape de dépôt de la couche d'oxy-nitrure.

### Brève description des figures

D'autres particularités et avantages ressortiront clairement de la description qui en est faite ci-après, à titre indicatif et nullement limitatif, en référence aux dessins annexés, dans lesquels :
- la figure 1 est un schéma synoptique représentant les étapes du procédé selon l'invention ;
- la figure 2 est une représentation schématique d'une vue en coupe d'un corps sur lequel une couche d'oxy-nitrure a été déposée ;
- les figures 3 à 6 sont des représentations schématiques de vues en coupe du corps de la figure 2 pendant les sous-étapes de structuration de la couche d'oxy-nitrure;
- la figure 7 est une représentation schématique d'une vue en coupe du corps obtenu après l'étape d'oxydation ; et
- la figure 8 est un exemple de pièce obtenue grâce au procédé selon l'invention.

### Description détaillée de l'invention

Comme expliqué ci-dessus, l'invention se rapporte à un procédé de réalisation 1 d'une pièce en céramique à effet nacré, notamment pour l'horlogerie, par exemple pour une boîte de montre, des maillons de bracelets, une lunette de montre, ou un cadran comportant des indices en céramique. Ce procédé 1 est bien-sûr utilisable pour n'importe qu'elle pièce en céramique, en dehors de l'horlogerie.

Le procédé 1 comprend une première étape 2 de formation d'un corps en céramique. En général, cette étape comprend plusieurs sous-étapes. Une première sous-étape consiste à réaliser un précurseur à partir d'un mélange d'au moins un matériau en poudre avec un liant. Ce matériau est de préférence de la céramique. Cette étape 2 est destinée à former un précurseur à partir d'une poudre à base de céramique prise dans le liant.

Dans ce contexte, la poudre à base de céramique peut comporter au moins un oxyde métallique, un nitrure métallique ou un carbure métallique. A titre d'exemple, la poudre à base de céramique peut comporter de l'oxyde d'aluminium ou un mélange d'oxyde d'aluminium et d'oxyde de chrome, ou encore de l'oxyde de zirconium. De plus, le liant peut être de natures variées comme, par exemple, de types polymères ou de types organiques.

La première étape 2 comporte ensuite une sous-étape de formation du corps vert, dans laquelle on donne une forme au corps vert correspondant à la pièce finale que l'on souhaite obtenir. A cette fin, on utilise de préférence un procédé de moulage par injection du précurseur dans un moule. Alternativement, on peut utiliser un procédé de pressage du précurseur avec un dispositif de pressage muni d'une matrice supérieure et d'une matrice inférieure entre lesquelles le précurseur est pressé.

La première étape 2 comporte une troisième sous-étape de frittage du corps vert afin de former un corps dur dans le matériau en céramique. Préférentiellement, la sous-étape de frittage peut comporter une pyrolyse. Pendant l'étape de frittage le corps se rétracte d'un coefficient dépendant de la matière le composant.

Le corps obtenu en céramique est de préférence monobloc, et comprend par exemple de la zircone, de préférence en totalité.

Dans une deuxième étape 3, le corps fritté est poli pour lui donner une surface lisse facilitant le dépôt de la troisième étape, et permet d'avoir un aspect esthétique avantageux pour les parties du corps en céramique qui resteront visibles pour la pièce finale.

La troisième étape 4 du procédé 1 consiste à déposer une couche d'un composé d'oxy-nitrure de type OxNy sur au moins une partie du corps en céramique. Le composé d'oxy-nitrure est à choisir de préférence parmi l'oxy-nitrure de zircone de type ZrOxNy, l'oxy-nitrure de Chrome de type CrOxN ou l'oxy-nitrure de Titane de type TrOxNy. La couche a de préférence une épaisseur comprise entre 50 et 1000nm, voire entre 100 et 500nm.

Le dépôt de la couche d'oxy-nitrure est de préférence effectuée par un dépôt physique en phase vapeur de type PVD. Par exemple, on utilise une méthode de déposition par pulvérisation réactive.

De manière optionnelle, le procédé 1 comprend une quatrième étape 5 de structuration de la couche du composé d'oxy-nitrure. Cette étape sert dans le cas où l'on souhaite avoir un motif nacré particulier. La structuration consiste à donner une forme à la couche d'oxy-nitrure en supprimant certaines parties de la couche. On peut par exemple choisir un motif correspondant à un Logo, une marque ou à des index de temps dessinés sur des lunettes.

Cette étape de structuration 5 est de préférence effectuée par photolithographie. La photolithographie consiste à déposer une couche de résine photosensible sur les parties de la couche à conserver pour les protéger et à graver chimiquement la couche d'oxy-nitrure pour enlever les parties qui ne sont pas protégées par le résine. Ainsi, on garde seulement une partie de la couche après disparition de la résine de protection.

En variante, la structuration peut être effectuée au moyen d'un laser, qui supprime des parties de la couche d'oxy-nitrure.

Dans une cinquième étape 6, on effectue une oxydation de la couche d'oxy-nitrure pour lui donner un aspect nacré ou irisé. Pour cela, la pièce est chauffée, de préférence dans un four. La pièce est chauffée à au moins 500°C, de préférence au moins 600°C. Le chauffage oxyde la couche ou les parties de couche d'oxy-nitrure, et les rend au moins en partie transparente. Cette couche en partie transparente donne l'effet nacré ou irisé.

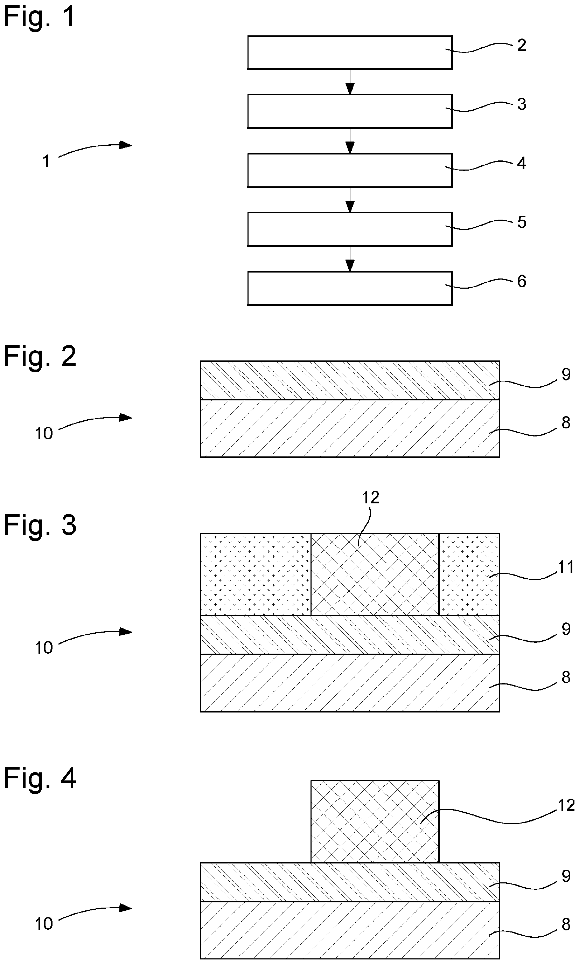

Les figures 2 à 7 montrent des illustrations des différentes étapes de réalisation d'une pièce selon le procédé décrit précédemment, en particulier pour les étapes de structuration de la couche d'oxy-nitrure.

Sur la figure 2, un corps 8 formé selon la première et la deuxième étape du procédé est recouvert d'une couche d'oxy-nitrure 9, selon la troisième étape du procédé par un procédé de type PVD.

Pour structurer la couche 9 et en sélectionner une partie à conserver, on procède à une photolithographie, dans laquelle on applique une résine photosensible 11 sur toute la couche 9. Un masque est disposé sur la résine 11 pour protéger une partie de la résine 11. Le masque a la forme que l'on souhaite obtenir pour la couche, soit en positif, soit en négatif, selon la résine utilisée.

L'ensemble est soumis à un rayonnement, de préférence ultraviolet, pour modifier les caractéristiques de la résine illuminée. On obtient ainsi deux portions de résine 11, 12, comme le montre la figure 3, l'une d'elle ayant été exposée au rayonnement, l'autre portion n'ayant pas été soumise au rayonnement.

Alternativement, on peut éviter l'utilisation d'un masque, et exposer directement la résine 11 avec une source à ultraviolet sélective, tel qu'un laser à ultraviolet.

Une des portions 11 de résine est éliminée, pour garder seulement une portion de résine 12 sur une partie de la couche d'oxy-nitrure, comme le montre la figure 4.

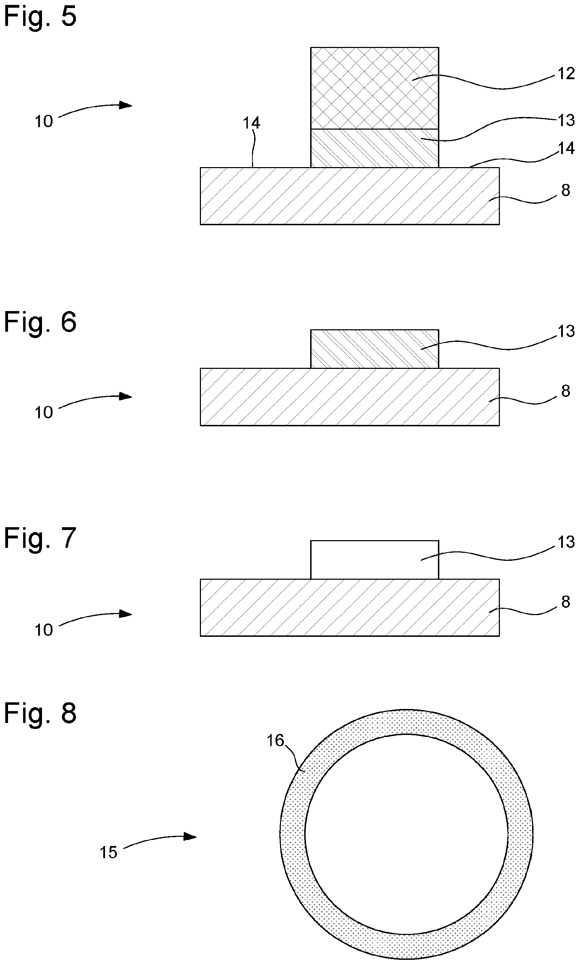

Sur la figure 5, par une sous-étape de gravure chimique, on enlève la partie de la couche d'oxy-nitrure 14, qui n'est pas protégée par la portion de résine restante 12. Ainsi, on obtient le corps 8 recouvert partiellement par une partie de la couche d'oxy-nitrure 13 et la portion de résine restante 12.

La portion de résine 12, qui a permis de protéger la partie de la couche sélectionnée, est ensuite éliminée pour garder seulement le corps et ladite partie.

Selon la cinquième étape du procédé, on oxyde la partie de couche d'oxy-nitrure 13 en la chauffant, selon la cinquième étape du procédé, afin de la rendre au moins en partie transparente. Ainsi, on obtient un corps 8 en céramique recouvert en partie par une couche transparente 13 produisant un effet irisé ou nacré.

La figure 8 est un exemple de pièce 15 en forme d'anneau en céramique pour une lunette de montre. Dans ce cas, l'anneau est presque totalement recouvert d'une couche irisée 16. On a utilisé le procédé décrit précédemment, l'étape de structuration de la couche d'oxy-nitrure servant par exemple à inscrire un logo sur l'anneau.

Une pièce peut être totalement recouverte d'une couche irisée, l'étape de structuration n'étant pas appliquée dans ce cas.

Bien entendu, la présente invention ne se limite pas à l'exemple illustré mais est susceptible de diverses variantes et modifications qui apparaîtront à l'homme de l'art.

## Revendications

1. Procédé de réalisation (1) d'une pièce (10, 15) en céramique à effet nacré, notamment pour l'horlogerie, **caractérisé en ce que** le procédé (1) comprend les étapes suivantes :
- une étape de formation (2) d'un corps (8) en céramique,
- une étape de dépôt (4) d'une couche (9) d'un composant d'oxynitrure de type OₓN_{y} sur au moins une partie (13) du corps (8) en céramique, et
- une étape d'oxydation (6) d'au moins une partie (13) de la couche d'oxy-nitrure (9), de préférence par chauffage.

2. Procédé selon la revendication 1, **caractérisé en ce que** l'étape de formation (2) du corps (8) en céramique comprend une sous-étape de réalisation d'un précurseur à partir d'un mélange d'au moins un matériau en poudre avec un liant.

3. Procédé selon la revendication 2, **caractérisé en ce que** l'étape de formation (2) du corps (8) en céramique comprend une sous-étape de formation d'un corps vert par injection dans un moule ou par pressage, le corps vert ayant la forme souhaitée pour le corps (8),

4. Procédé selon la revendication 3, **caractérisé en ce que** l'étape de formation (2) du corps (8) en céramique comprend une sous-étape de frittage du corps vert afin de le durcir et d'obtenir la forme souhaitée,

5. Procédé selon l'une, quelconque, des revendications précédentes, **caractérisé en ce que** le corps (8) formé lors de l'étape de formation (2) du corps (8) est monobloc, et de préférence en céramique blanche ;

6. Procédé selon l'une, quelconque, des revendications précédentes, **caractérisé en ce qu'**il comprend une étape de structuration (5) de la couche du composant d'oxy-nitrure avant l'étape d'oxydation de la couche (6).

7. Procédé selon la revendication 6, **caractérisé en ce que** l'étape de structuration (5) est effectuée par photolithographie ou par ablation directe, par exemple par laser.

8. Procédé selon l'une, quelconque, des revendications précédentes, **caractérisé en ce que** le composant d'oxy-nitrure est à choisir parmi l'oxy-nitrure de zircone de type ZᵣOₓN_{y}, l'oxy-nitrure de Chrome de type CrOxN ou l'oxy-nitrure de Titane de type TᵣOₓN_{y}.

9. Procédé selon l'une, quelconque, des revendications précédentes, **caractérisé en ce que** le corps (8) est chauffé à au moins 500°C, de préférence au moins 600°C, lors de l'étape d'oxydation (6).

10. Procédé selon, l'une quelconque, des revendications précédentes, **caractérisé en ce que** l'étape de dépôt de la couche d'oxy-nitrure (4) est effectuée par un dépôt physique en phase vapeur de type PVD.

11. Procédé selon l'une, quelconque, des revendications précédentes, **caractérisé en ce que** le corps (8) en céramique formé lors de l'étape de formation (2) du corps (8) comprend de la zircone, de préférence en totalité.

12. Procédé selon l'une, quelconque, des revendications précédentes, **caractérisé en ce qu'**il comprend une étape de polissage (3) du corps (8) avant l'étape de dépôt de la couche d'oxy-nitrure (9).
